# EUROPÄISCHE PATENTSCHRIFT

(11) **EP 3 187 886 B1**
(45) Veröffentlichungstag und Bekanntmachung des Hinweises auf die Patenterteilung: **30.03.2022**
(21) Anmeldenummer: 15203089.6
(22) Anmeldetag: 30.12.2015
(51) Int. Cl.: G01R 22/06, G01R 1/04, G01R 21/133, H02B 1/21

(54) **MESSMODUL FÜR EIN STROMSAMMELSCHIENENSYSTEM**
MEASURING MODULE FOR A BUSBAR SYSTEM
MODULE DE MESURE POUR UN SYSTEME DE BARRE OMNIBUS

(43) Veröffentlichungstag der Anmeldung: 05.07.2017
(73) Patentinhaber: Wöhner GmbH & Co. KG Elektrotechnische Systeme, 96472 Rödental (DE)
(72) Erfinder: Lenker, Hubert, 96515 Sonnenberg (DE); Steinberger, Philipp, 96450 Coburg (DE)
(74) Vertreter: Isarpatent

(56) Entgegenhaltungen:
- EP-A2- 1 206 046
- AT-U2- 2 973
- CN-U- 204 028 223
- CN-U- 204 116 416
- CN-U- 204 905 590
- DE-U1- 8 236 122
- DE-U1- 9 116 090
- KR-B1- 101 035 941
- US-A1- 2004 178 875
- US-A1- 2006 243 569
- Olympia Business Systems Vertriebs Gmbh: "Energiekosten-Messgerät Modell EKM 2100", , 4. Februar 2014 (2014-02-04), XP055278004, Gefunden im Internet: URL:http://cdn-reichelt.de/documents/daten blatt/D700/EKM2100.pdf [gefunden am 2016-06-06]
- Www Eutrac Com: ". ASSEMBLY INSTRUCTIONS . MONTAGEANLEITUNG . 99-095-. 3 Circuit ( 230V ) Tracks and Adaptors 3 Phasen ( 230V ) Stromschienen und Adaptoren", , 5 April 2011 (2011-04-05), XP055456489, Retrieved from the Internet: URL:http://www.eutrac.de/media/pdf/MT_6.16 8-0.pdf [retrieved on 2018-03-05]

## Beschreibung

Die Erfindung betrifft ein Messmodul für ein Stromsammelschienensystem mit mehreren parallel verlaufenden Stromsammelschienen zur Stromversorgung von Verbrauchseinheiten bzw. Lasten über ein Schaltgerät. Derartige Schaltgeräte umfassen beispielsweise Sicherungslasttrennschalter oder Leistungsschutzschalter. Herkömmliche Stromsammelschienensysteme umfassen in der Regel drei parallel angeordnete Stromsammelschienen für verschiedene Stromphasen L1, L2, L3. Ein Schaltgerät kann dabei mithilfe eines Stromsammelschienenadapters auf die parallel angeordneten Stromsammelschienen aufgesetzt werden. Das aufgesetzte Schaltgerät wird dann an eine Last bzw. einen elektrischen Verbraucher angeschlossen.

Eine herkömmliche Verschaltung einer Last an ein Stromsammelschienensystem, beispielsweise mittels eines Adapters und eines Schaltgerätes, bietet allerdings keine Möglichkeit, in einfacher Weise Stromparameter und/oder Spannungsparameter während des Betriebes des angeschlossen elektrischen Verbrauchers zu messen.

Des Weiteren ist aus der EP 1 206 046 A2 eine Vorrichtung zur Durchführung sowohl von Messungen als auch von Datenübertragungen in elektrischen Energieverteilnetzen offenbart. Weitere ist aus der KR 101 035 941 B1 eine Energieverbrauchs-Bestimmungsvorrichtung bekannt, welche mit einem Ende an eine erste Mehrfachdeckdose angeschlossen ist, über welche Strom aufgenommen wird. Mit dem anderen Ende ist die Energieverbrauchs-Bestimmungsvorrichtung an eine zweite Mehrfachsteckdose angeschlossen, an welche mehrere Stromverbraucher angeschlossen sind. Weiterhin offenbart CN 204 116 416 U einen Stromzähler, der ein Steckergehäuse mit außenliegenden externen Anschlussplatten für eine externe Verdrahtung und in seitlichen Gehäuseöffnungen des Steckergehäuses Steckergehäuse-Kontaktklemmen aufweist.

In der Montageanleitung "Assembly Instructions. Montageanleitung. 99-095-. 3 Circuit (230V) Tracks and Adaptors 3 Phasen (230V) Stromschienen und Adaptoren ist eine Montage eines SteckdosenMultiAdapters offenbart.

Es ist daher eine Aufgabe der vorliegenden Erfindung, ein Messmodul für ein Stromsammelschienensystem zu schaffen, welches es erlaubt, in einfacher Weise Stromparameter und/oder Spannungsparameter während des Betriebes eines elektrischen Verbrauchers, der über ein Schaltgerät an das Stromsammelschienensystem angeschlossen ist, zu messen.

Sowohl der Sammelschienenadapter, als auch das Messmodul sind vorzugsweise berührungsgeschützt aufgebaut. Dies führt dazu, dass die das Messmodul und/oder das Schaltgerät unter Spannung montiert bzw. demontiert werden können.

Diese Aufgabe wird erfindungsgemäß durch ein Messmodul mit den in Patentanspruch 1 angegebenen Merkmalen gelöst.

Bei einer möglichen Ausführungsform des erfindungsgemäßen Messmoduls weist das Messmodul eine an die Messeinheit angeschlossene Sendeeinheit auf, welche die von der Messeinheit gelieferten Messergebnisse an eine mit der externen Auswerteeinheit verbundene Empfangseinheit drahtlos, d.h. optisch oder per Funk, überträgt.

Bei einer weiteren möglichen Ausführungsform des erfindungsgemäßen Messmoduls erfolgt die Messung der Stromstärken I der Stromphasen L mittels in dem Messmodul enthaltener Rogowski-Spulen oder mittels Shunts oder mittels Hallsensoren oder mittels Stromwandlern bzw. Transformatoren.

Bei einer weiteren möglichen Ausführungsform des erfindungsgemäßen Messmoduls erfolgt die Messung der Stromstärken I der Stromphasen L mittels GMR-Sensoren.

Bei einer weiteren möglichen Ausführungsform des erfindungsgemäßen Messmoduls überwacht die externe Auswerteeinheit das Messmodul hinsichtlich seiner fehlerfreien Funktionsweise.

Bei einer weiteren möglichen Ausführungsform des erfindungsgemäßen Messmoduls bezieht die in dem Messmodul enthaltene Messeinheit ihre Strom- bzw. Spannungsversorgung durch die von dem Stromsammelschienenadapter abgegriffenen Stromphasen (L) des Stromsammelschienensystems.

Bei einer weiteren möglichen Ausführungsform des erfindungsgemäßen Messmoduls werden die von der Messeinheit gelieferten Messergebnisse von der Sendeeinheit zu der Empfangseinheit über eine optische Koppelung, beispielsweise im Infrarot-Frequenzbereich, übertragen. Alternativ erfolgt die Signalübertragung per Funk, beispielsweise per NFC-Verbindung.

Bei einer weiteren möglichen Ausführungsform des erfindungsgemäßen Messmoduls ist das über das eingesetzte Messmodul an das Stromsammelschienensystem angeschlossene elektrische Gerät ein Sicherungslasttrennschalter.

Bei einer weiteren möglichen Ausführungsform des erfindungsgemäßen Messmoduls ist das über das eingesetzte Messmodul an das Stromsammelschienensystem angeschlossene elektrische Gerät ein Leistungsschalter.

Bei einer weiteren möglichen Ausführungsform des erfindungsgemäßen Messmoduls ist das über das eingesetzte Messmodul an das Stromsammelschienensystem angeschlossene elektrische Gerät ein Vorrichtung zur sicherungslosen Einspeisung .

Die Erfindung schafft ferner ein Stromsammelschienensystem mit den in Patentanspruch 11 angegebenen Merkmalen.

Im Weiteren werden mögliche Ausführungsformen des erfindungsgemäßen Messmoduls und des erfindungsgemäßen Stromsammelschienensystems unter Bezugnahme auf die beigefügten Figuren näher erläutert.

Es zeigen:
- Fig. 1: ein Schaltungsdiagramm zur Erläuterung eines Ausführungsbeispiels des erfindungsgemäßen Messmoduls;
- Fig. 2: eine perspektivische Ansicht zur Darstellung eines Ausführungsbeispiels des erfindungsgemäßen Stromsammelschienensystems.

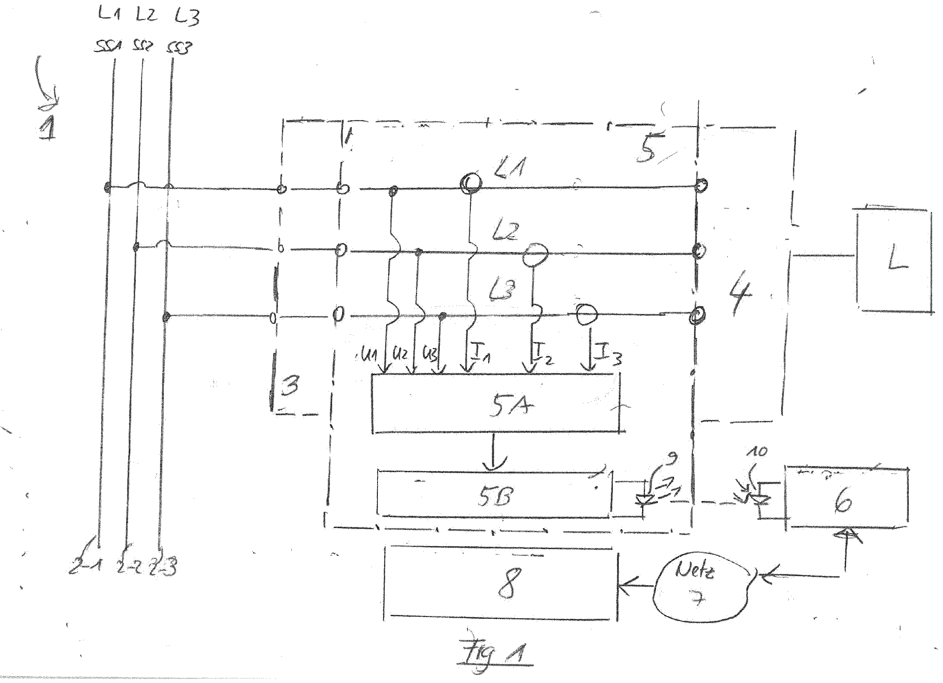

Wie man aus Fig. 1 erkennen kann, verfügt ein Stromsammelschienensystem 1 bei dem dargestellten Ausführungsbeispiel über drei Stromsammelschienen 2-1, 2-2, 2-3 für drei verschiedene Stromphasen L1, L2, L3. Die Stromsammelschienen sind dabei vorzugsweise zueinander parallel angeordnet. Die Stromsammelschienen 2-1, 2-2, 2-3 können dabei beispielsweise in horizontaler oder vertikaler Richtung ausgerichtet sein.

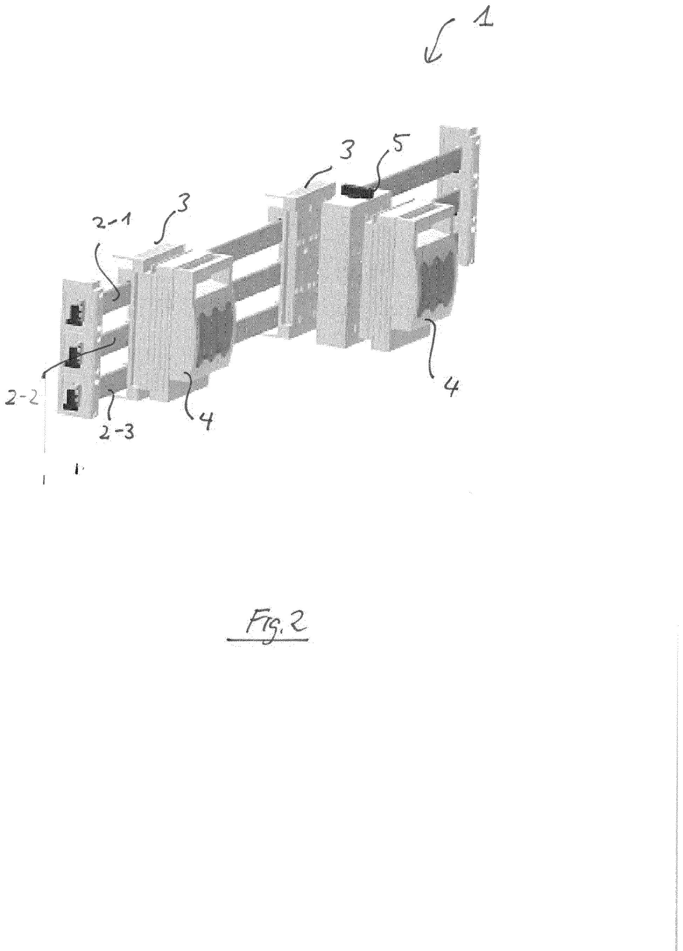

Das Stromsammelschienensystem 1 verfügt, wie in Fig. 1 dargestellt, über einen auf die Stromsammelschienen 2-i aufgesetzten Stromsammelschienenadapter 3. Der Stromsammelschienenadapter 3 ist auch in der perspektivischen Ansicht von Fig. 2 dargestellt. Dieser Stromsammelschienenadapter 3 dient normalerweise zum Anschluss eines elektrischen Geräts bzw. Schaltgerätes 4 an das Stromsammelschienensystem 1. Das in Fig. 2 links dargestellte Schaltgerät 4 ist beispielsweise ein Sicherungslasttrennschalter, ein Leistungsschalter oder ein sonstiges Stromeinspeisemodul für eine elektrische Last bzw. einen elektrischen Verbraucher. Zum direkten Anschluss eines elektrischen Verbrauchers wird zunächst der Stromsammelschienenadapter 3 auf die parallel angeordneten Stromsammelschienen 2-i des Stromsammelschienensystems 1 aufgesetzt. Anschließend wird das Schaltgerät bzw. elektrische Gerät 4 an dem Stromsammelschienenadapter 3 angebracht. Schließlich wird die elektrische Last bzw. der Verbraucher an das Schaltgerät bzw. elektrische Gerät 4 angeschlossen. Auch eine umgekehrte Stromrichtung ist möglich, d.h. der Sicherungslasttrennschalter oder der Leistungsschalter fungiert als Einspeisung für das Sammelschienensystem. Bei der in Fig. 2 links dargestellten Anordnung erfolgt somit ein Anschluss der Last ohne Einsetzen eines Messmoduls. Demgegenüber erfolgt bei der in Fig. 2 rechts dargestellten Schaltanordnung der Anschluss einer elektrischen Last L über das Schaltgerät bzw. elektrische Gerät 4 und über ein zwischen dem Stromsammelschienenadapter 3 und dem Schaltgerät 4 vorgesehenes Messmodul 5. Dieses Messmodul 5 ist, wie in Fig. 1 dargestellt, zwischen dem Stromsammelschienenadapter 3 und dem Schaltgerät bzw.

elektrischen Gerät 4 verschaltet. Das Messmodul 5 ist zwischen dem Stromsammelschienenadapter 3 und dem Schaltgerät bzw. elektrischen Gerät 4 einsetzbar. Beispielsweise kann ein Nutzer das Schaltgerät bzw. elektrische Gerät 4 von dem Adapter 3 abnehmen und das erfindungsgemäße Messmodul 5 zwischen dem Stromsammelschienenadapter 3 und dem Schaltgerät bzw. elektrischen Gerät 4 einsetzen, wie in Fig. 2 rechts dargestellt.

Das Messmodul 5 verfügt über eine Messeinheit 5A, welche gleichzeitig die Spannungen U1, U2, U3, die Stromstärken I1, 12, 13 und die Phasenverschiebungen Δϕ der an das Schaltgerät 4 über das eingesetzte Messmodul 5 angelegten Stromphasen L1, L2, L3 misst. Das Messmodul 5 weist bei der in Fig. 1 dargestellten Ausführungsform neben der Messeinheit 5A eine Sendeeinheit 5B auf, die die Messergebnisse an eine externe Auswerteeinheit meldet. Bei dem in Fig. 1 dargestellten Ausführungsbeispiel überträgt die Sendeeinheit 5B die von der Messeinheit 5A gelieferten Messergebnisse an eine externe Empfangseinheit 6 mittels optischer Signale. Die Empfangseinheit 6 ist bei dem dargestellten Ausführungsbeispiel über ein Netz, insbesondere ein Datennetz 7, mit einer externen Auswerteeinheit 8, beispielsweise einem Rechner, verbunden. Bei einer möglichen Ausführungsform verfügt die Sendeeinheit 5B über eine lichtemittierende Diode 9 zur Ausstrahlung von optischen Datensignalen, die durch eine fotoempfindliche Diode 10 der Empfangseinheit 6 empfangen wird. Die Sendeeinheit 5B und die Empfangseinheit 6 sind somit galvanisch entkoppelt. Bei einer möglichen Ausführungsform werden die von der Messeinheit 5A gelieferten Messergebnissen von der Sendeeinheit 5B im Infrarot-Frequenzbereich übertragen. In dem Messmodul 5 werden vorzugsweise gleichzeitig Spannungen, Stromstärken und Phasenverschiebungen aller drei Phasen (L1, S2, S3) gemessen. Bei einer bevorzugten Ausführungsform bezieht die in dem Messmodul 5 enthaltene Messeinheit 5A ihre Strom- bzw. Spannungsversorgung direkt durch die von dem Stromsammelschienenadapter 3 abgegriffenen Stromphasen L des Stromsammelschienensystems 1. Bei einer möglichen Ausführungsform bezieht auch die Sendeeinheit 5B der Stromversorgung von den abgegriffenen Stromphasen L des Stromsammelschienensystems 1.

Die Messergebnisse bzw. Messwerte werden potentialfrei über eine optische Übertragungsstrecke oder eine Funkübertragungsstrecke an die Auswerteeinheit 8 übertragen. Bei einer bevorzugten Ausführungsform ist die optische Übertragungsstrecke bidirektional, d.h. die Auswerteeinheit 8 kann über die optische Übertragungsstrecke nun auch Signale, insbesondere Steuersignale, an eine in dem Messmodul 5 enthaltene Empfangseinheit 6 übertragen, um die Messeinheit 5A während der Messung zu steuern. Die Auswerteeinheit 8 kann bei einer möglichen Ausführungsform erkennen, inwieweit das Messmodul 5 Fehlmessungen vornimmt bzw. ausfällt, d.h. die Auswerteeinheit 8 kann eine Watchdog-Funktion ausüben. Bei einer möglichen Ausführungsform kann die Auswerteeinheit 8, beispielsweise ein Rechner, Testgrenzwerte vorgeben und über die bidirektionale Kommunikationsschnittstelle an das Messmodul 5 übertragen.

Die Vorgabewerte, beispielsweise Maximalwerte, können dabei bei einer möglichen Ausführungsform in einem internen Datenspeicher des Messmoduls 5 gespeichert werden. Bei einer möglichen Ausführungsform werden somit Testparameter bzw. Messschwellenwerte über die bidirektionale optische Schnittstelle innerhalb des Messmoduls 5 konfiguriert. Eine Rücksetzung oder Änderung der konfigurierten Messparameter kann über die bidirektionale optische Kommunikationsstrecke erfolgen. Bei einer möglichen Ausführungsform erfolgt die Strommessung der Stromstärken I der Stromphasen L mittels Rogowski-Spulen, die in dem Messmodul 5 enthalten sind. Derartige Rogowski-Spulen halten Kurzschlussströme in einem Hauptstromkreis problemlos aus. Zur Erhöhung der Messgenauigkeit bzw. Messempfindlichkeit kann dabei eine 3D-Kompensation vorgenommen werden. In gleicher Weise kann auch eine Unempfindlichkeit gegenüber magnetischen Fremdstörfeldern durch 3D-Kompensation erreicht werden. Bei einer weiteren möglichen Ausführungsform des erfindungsgemäßen Messmoduls 5 werden die Stromstärken I der Stromphasen L mittels integrierter GMR-Sensoren der Messeinheit 5A gemessen.

Das erfindungsgemäße Messmodul 5 bietet den Vorteil, dass es in einfacher Weise ohne großen schaltungstechnischen Aufwand zwischen einem Schaltgerät 4 und einem Stromsammelschienenadapter 3 einsteckbar ist, um unmittelbar Messungen an dem Stromsammelschienensystem 1 vorzunehmen. Durch den besonderen Aufbau des Stromsammelschienenadapters 3 und des Messmoduls kann dies auch geschehen, wenn die Sammelschienen unter Spannung stehen. Die Kontakte sind vorzugsweise fingersicher (IP20) in dem Messmodul eingebracht. Nach vollzogener Messung kann das Messmodul 4 auch wieder entfernt werden und an anderer Stelle innerhalb des Stromsammelschienensystems 1 eingesetzt werden, beispielsweise zwischen einem anderen Stromsammelschienenadapter 3 und einem zugehörigen anderen Schaltgerät 4. Weiterhin bietet das erfindungsgemäße Messmodul 5 den Vorteil, dass bestehende Stromsammelschienensysteme 1 ohne Probleme nachrüstbar sind, indem das Messmodul 5 einfach zwischen dem aufgesetzten Stromsammelschienenadapter 3 und seinem zugehörigen Schaltgerät 4 eingesetzt wird. Das Messmodul 5 wird in die elektromechanische Schnittstelle zwischen einem Stromsammelschienenadapter 3 und einer Systemkomponente bzw. einem Schaltgerät 4 eingefügt. Die Auswerteeinheit 8 kann sich in unmittelbarer Nähe des Messmoduls 5 befinden und beispielsweise über ein lokales Netz mit einer Empfangseinheit 6 verbunden sein. Alternativ kann die Auswerteeinheit 8 auch eine entfernte Auswerteeinheit 8 sein, die über ein Datennetzwerk 7 mit einem entfernten Messmodul 5 verbunden ist. Bei einer möglichen Ausführungsform ist die Auswerteeinheit 8 über ein Datennetzwerk 7 mit einer Vielzahl unterschiedlicher Messmodule 5 verbunden, welche an verschiedenen Stellen eines verteilten Stromsammelschienensystems angebracht sind. Hierdurch kann die Auswerteeinheit 8 zentral verschiedene Stromparameter und/oder Spannungsparameter an verschiedenen Stellen des Stromsammelschienensystems 1 überwachen und ggf. durch Steuersignale entsprechende Aktoren innerhalb des Stromsammelschienensystems 1 schalten.

## Patentansprüche

1. Messmodul (5) für ein Stromsammelschienensystem (1), bei dem ein elektrisches Gerät (4) über einen auf Stromsammelschienen (2-i) aufgesetzten Stromsammelschienenadapter (3) zur Verbindung mit Stromphasen (L) an die Stromsammelschienen des Stromsammelschienensystems (1) kontaktierbar ist,
wobei das Messmodul (5) zwischen dem Stromsammelschienenadapter (3) und dem elektrischen Gerät (4) einsetzbar ist und eine Messeinheit (5A) enthält, welche als elektrische Kennwerte die Phasenverschiebungen (Δϕ) der an das elektrische Gerät (4) über das eingesetzte Messmodul (5) angelegten Stromphasen (L), misst und die Messergebnisse an eine externe Auswerteeinheit (8) meldet, wobei das Messmodul (5) konstruktiv derart ausgeführt ist, dass das Messmodul (5) auf den Stromsammelschienenadapter (3) aufgesetzt werden kann, wenn dieser unter elektrischer Spannung steht, ohne dass eine Gefahr für den Anwender besteht und wobei das Messmodul (5) eine an die Messeinheit (5A) angeschlossene Sendeeinheit (5B) aufweist, wobei Kontakte des Messmoduls (5) fingersicher in dem Messmodul (5) eingebracht sind, so dass das Messmodul und/oder das elektrische Gerät unter Spannung montiert bzw. demontiert werden können.

2. Messmodul nach Anspruch 1,
wobei die Messeinheit (5A) die Spannungen (U) oder die Stromstärken (I) misst.

3. Messmodul nach Anspruch 1 oder 2,
wobei die Sendeeinheit (5B) die von der Messeinheit (5A) gelieferten Messergebnisse an die mit der externen Auswerteeinheit (8) verbundene Empfangseinheit (6) optisch oder per Funk überträgt.

4. Messmodul nach Anspruch 3,
wobei die Sendeeinheit (5B) die von der Messeinheit (5A) gelieferten Messergebnisse an die mit der externen Auswerteeinheit (8) verbundene Empfangseinheit (6) optisch über eine optische Übertragungsstrecke überträgt, wobei die optische Übertragungsstrecke bidirektional ist, so dass die Auswerteeinheit auch Signale an die Empfangseinheit (6) übertragen kann.

5. Messmodul nach einem der Ansprüche 1 bis 4,
wobei die Messung der Stromstärken (I) der Stromphasen (L) mittels in dem Messmodul (5) enthaltener Rogowski-Spulen, GMR-Sensoren, Shunts, Hallsensoren oder mittels Stromwandlern, insbesondere Transformatoren, erfolgt.

6. Messmodul nach einem der vorangehenden Ansprüche 1 bis 5,
wobei die externe Auswerteeinheit (8) das Messmodul (5) hinsichtlich seiner fehlerfreien Funktionsweise überwacht.

7. Messmodul nach Anspruch 3, 4, 5 oder 6,
wobei die externen Auswerteeinheit (8) Testgrenzwerte vorgibt und über die bidirektionale optische Übertragungsstrecke an das Messmodul (5) übertragen kann.

8. Messmodul nach einem der vorangehenden Ansprüche 1 bis 7,
wobei die in dem Messmodul (5) enthaltene Messeinheit (5A) ihre Stromversorgung durch die von dem Stromsammelschienenadapter abgegriffenen Stromphasen (L) des Stromsammelschienensystems bezieht.

9. Messmodul nach einem der vorangehenden Ansprüche 2 bis 8,
wobei die Messeinheit (5A) von der Empfangseinheit (6) galvanisch getrennt ist und eine Signalübertragung über eine optische Kopplung oder per Funk, insbesondere NFC, erfolgt.

10. Messmodul nach einem der vorangehenden Ansprüche 1 bis 9,
wobei das über das eingesetzte Messmodul (5) an das Stromsammelschienensystem (1) angeschlossene elektrische Gerät(4) ein Sicherungslasttrennschalter, ein Leistungsschalter oder eine Vorrichtung zur sicherungslosen Stromversorgung, insbesondere ein Einspeisemodul, ist.

11. Stromsammelschienensystem (1) mit
mehreren Stromsammelschienen (2),
einem auf die Stromsammelschienen (2) aufgesetzten Stromsammelschienenadapter (3),
einem auf den Stromsammelschienenadapter (3) aufgesetzten Messmodul (5) nach einem der vorangehenden Ansprüche 1 bis 10 und mit einem elektrischen Gerät (4), das über das Messmodul (5) mit dem Stromsammelschienenadapter (3) verbunden ist.

12. Stromsammelschienensystem nach Anspruch 11,
wobei an das elektrische Gerät (4) eine elektronische Last (L) angeschlossen ist.

13. Stromsammelschienensystem nach Anspruch 11 oder 12,
wobei das Schaltgerät (4) einen Sicherungslasttrennschalter, Leistungsschalter oder ein Einspeisemodul aufweist.

## Claims

1. Measuring module (5) for a busbar system (1), in which an electrical device (4) is contactable with the busbars of the busbar system (1), via a busbar adapter (3) placed on busbars (2-i), for connection to current phases (L),
wherein the measuring module (5) is insertable between the busbar adapter (3) and the electrical device (4) and contains a measuring unit (5A) which measures, as electrical characteristic values, the phase shifts (Δϕ) in the current phases (L) applied to the electrical device (4) via the inserted measuring module (5), and reports the measurement results to an external evaluation unit (8), the measuring module (5) being constructionally configured in such a way that the measuring module (5) can be placed on the busbar adapter (3) when said adapter is under electrical voltage, without there being a risk for the user, and the measuring module (5) having a transmission unit (5B) connected to the measuring unit (5A), contacts of the measuring module (5) being introduced into the measuring module (5) in a finger-safe manner, in such a way that the measuring module and/or the electrical device can be mounted and dismounted live.

2. Measuring module according to claim 1,
wherein the measuring unit (5A) measures the voltages (U) or currents (I).

3. Measuring module according to either claim 1 or claim 2,
wherein the transmission unit (5B) transmits, optically or by radio, the measurement results supplied by the measuring unit (5A) to the receiving unit (6) connected to the external evaluation unit (8).

4. Measuring module according to claim 3,
wherein the transmission unit (5B) transmits, optically via an optical transmission path, the measurement results supplied by the measurement unit (5A) to the receiving unit (6) connected to the external evaluation unit (8), the optical transmission path being bidirectional in such a way that the evaluation unit can also transmit signals to the receiving unit (6).

5. Measuring module according to any of claims 1 to 4,
wherein the currents (I) of the current phases (L) are measured by means of Rogowski coils, GMR sensors, shunts or Hall effect sensors contained in the measuring module (5) or by means of current converters, in particular transformers.

6. Measuring module according to any of preceding claims 1 to 5,
wherein the external evaluation unit (8) monitors the measuring module (5) for error-free operation.

7. Measuring module according to claim 3, 4, 5 or 6,
wherein the external evaluation unit (8) specifies test limits and can transmit them to the measuring module (5) via the bidirectional optical transmission path.

8. Measuring module according to any of preceding claims 1 to 7,
wherein the measuring unit (5A) contained in the measuring module (5) draws its power supply from the current phases (L) of the busbar system which are tapped by the busbar adapter.

9. Measuring module according to any of preceding claims 2 to 8,
wherein the measuring unit (5A) is galvanically separated from the receiving unit (6) and signal transmission takes place via an optical coupling or by radio, in particular NFC.

10. Measuring module according to any of preceding claims 1 to 9,
wherein the electrical device (4) connected to the busbar system (1) via the inserted measuring module (5) is a safety circuit breaker, a power switch or a device for fu-seless power supply, in particular a supply module.

11. Busbar system (11), comprising
a plurality of busbars (2),
a busbar adapter (3) placed on the busbars (2),
a measuring module (5) according to any of preceding claims 1 to 10, placed on the busbar adapter (3),
and comprising an electrical device (4) connected to the busbar adapter (3) via the measuring module (5).

12. Busbar system according to claim 11,
wherein an electronic load (L) is connected to the electrical device (4).

13. Busbar system according to either claim 11 or claim 12,
wherein the electric device (4) has a safety circuit breaker, a power switch or a supply module.

## Revendications

1. Module de mesure (5) pour un système de barres collectrices de courant (1), dans lequel un appareil électrique (4) peut être mis en contact avec les barres collectrices de courant du système de barres collectrices de courant (1) par l'intermédiaire d'un adaptateur de barres collectrices de courant (3) monté sur des barres collectrices de courant (2-i) pour la liaison avec des phases de courant (L),
dans lequel le module de mesure (5) peut être inséré entre l'adaptateur de barres collectrices de courant (3) et l'appareil électrique (4) et contient une unité de mesure (5A) qui mesure, en tant que valeurs électriques caractéristiques, les déphasages (Δϕ) des phases de courant (L) appliquées à l'appareil électrique (4) par l'intermédiaire du module de mesure (5) inséré et communique les résultats de mesure à une unité d'évaluation externe (8), dans lequel le module de mesure (5) est réalisé de manière constructive de telle sorte que le module de mesure (5) peut être monté sur l'adaptateur de barres collectrices de courant (3) lorsque celui-ci est sous tension électrique sans qu'il existe un danger pour l'utilisateur, et dans lequel le module de mesure (5) présente une unité d'émission (5B) raccordée à l'unité de mesure (5A), des contacts du module de mesure (5) étant placés dans le module de mesure (5) de manière à être protégés contre le contact avec les doigts, de sorte que le module de mesure et/ou l'appareil électrique peuvent être montés ou démontés sous tension.

2. Module de mesure selon la revendication 1,
dans lequel l'unité de mesure (5A) mesure les tensions (U) ou les intensités de courant (I).

3. Module de mesure selon la revendication 1 ou 2,
dans lequel l'unité d'émission (5B) transmet les résultats de mesure fournis par l'unité de mesure (5A) à l'unité de réception (6) reliée à l'unité d'évaluation externe (8) par voie optique ou par radio.

4. Module de mesure selon la revendication 3,
dans lequel l'unité d'émission (5B) transmet les résultats de mesure fournis par l'unité de mesure (5A) à l'unité de réception (6) reliée à l'unité d'évaluation externe (8) par voie optique via une liaison de transmission optique, dans lequel la liaison de transmission optique est bidirectionnelle, de sorte que l'unité d'évaluation peut également transmettre des signaux à l'unité de réception (6).

5. Module de mesure selon l'une des revendications 1 à 4,
dans lequel la mesure des intensités de courant (I) des phases de courant (L) s'effectue au moyen de bobines de Rogowski, de capteurs GMR, de shunts, de capteurs à effet Hall ou de convertisseurs de courant, en particulier de transformateurs, contenus dans le module de mesure (5).

6. Module de mesure selon l'une des revendications 1 à 5 précédentes,
dans lequel l'unité d'évaluation externe (8) surveille le module de mesure (5) en ce qui concerne son fonctionnement sans défaut.

7. Module de mesure selon les revendications 3, 4, 5 ou 6,
dans lequel l'unité d'évaluation externe (8) prédéfinit des valeurs limites de test et peut les transmettre au module de mesure (5) via la liaison de transmission optique bidirectionnelle.

8. Module de mesure selon l'une des revendications 1 à 7 précédentes,
dans lequel l'unité de mesure (5A) contenue dans le module de mesure (5) reçoit son alimentation électrique par les phases de courant (L) du système de barres collectrices de courant prélevées par l'adaptateur de barres collectrices de courant.

9. Module de mesure selon l'une des revendications 2 à 8 précédentes,
dans lequel l'unité de mesure (5A) est isolée galvanique-ment de l'unité de réception (6) et la transmission des signaux s'effectue par couplage optique ou par radio, en particulier par NFC.

10. Module de mesure selon l'une des revendications 1 à 9 précédentes,
dans lequel l'appareil électrique (4) raccordé au système de barres collectrices de courant (1) par l'intermédiaire du module de mesure (5) inséré est un interrupteur-sectionneur à fusible, un disjoncteur ou un dispositif d'alimentation électrique sans fusible, en particulier un module d'alimentation.

11. Système de barres collectrices de courant (1) comportant plusieurs barres collectrices de courant (2),
un adaptateur de barres collectrices de courant (3) monté sur les barres collectrices de courant (2),
un module de mesure (5) selon l'une des revendications 1 à 10 précédentes, monté sur l'adaptateur de barres collectrices de courant (3), et
un appareil électrique (4) qui est relié à l'adaptateur de barres collectrices de courant (3) par l'intermédiaire du module de mesure (5).

12. Système de barres collectrices de courant selon la revendication 11,
dans lequel une charge électronique (L) est raccordée à l'appareil électrique (4).

13. Système de barres collectrices de courant selon la revendication 11 ou 12,
dans lequel l'appareil électrique (4) présente un interrupteur-sectionneur à fusible, un disjoncteur ou un module d'alimentation.
